(19) Europäisches Patentamt
European Patent Office
Office européen des brevets

(11) **EP 4 648 253 A1**

(12) **EUROPEAN PATENT APPLICATION**

(43) Date of publication:
**12.11.2025 Bulletin 2025/46**

(21) Application number: **25162492.0**

(22) Date of filing: **10.03.2025**

(51) International Patent Classification (IPC):
*H02J 7/00* *(2006.01)*

(52) Cooperative Patent Classification (CPC):
**H02J 7/0016; H02J 7/0069;** H02J 7/007194

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **09.05.2024 KR 20240061417**

(71) Applicant: **SAMSUNG SDI CO., LTD.**
**Yongin-si, Gyeonggi-do 17084 (KR)**

(72) Inventors:
• **KIM, Minsu**
**17084 Yongin-si (KR)**
• **YU, Jae-Seung**
**17084 Yongin-si (KR)**

(74) Representative: **Regimbeau**
**20, rue de Chazelles**
**75847 Paris Cedex 17 (FR)**

(54) **CELL BALANCING METHOD, AND CELL BALANCING DEVICE AND BATTERY PACK PERFORMING THE SAME**

(57)     The present disclosure relates to a cell balancing method and a cell balancing device performing the cell balancing method, and a battery pack. The cell balancing device may include: a storage device that storage a balancing profile for cell balancing; a balancing device configured to perform a discharge function for cell balancing of a plurality of battery cells; and a first controller configured to control the balancing device to perform pulse discharge for a balancing target battery cell selected from among the plurality of battery cells referring to the balancing profile if the cell balancing is required. The balancing profile may include a pulse period and a duty cycle set based on a natural frequency of a dendrite. The balancing device may be further configured to perform the pulse discharge according to a pulse signal that satisfies the pulse period and the duty cycle.

FIG. 1

## Description

### BACKGROUND OF THE INVENTION

#### (a) Field of the Invention

The present disclosure relates to a cell balancing method, a cell balancing device performing the cell balancing, and a battery pack.

#### (b) Description of the Related Art

A rechargeable battery is a battery that is capable of being repeatedly charged and discharged, unlike a primary battery that is incapable of being recharged. Low-capacity rechargeable batteries are used in portable small electronic devices such as smart phones, feature phones, laptop computers, digital cameras, and camcorders, while large-capacity rechargeable batteries are widely used as power and electric power storage device for driving motors of hybrid vehicles, electric vehicles, and the like. The rechargeable battery includes an electrode assembly formed of a positive electrode and a negative electrode, a case accommodating the electrode assembly, and an electrode terminal connected to the electrode assembly.

A lithium ion battery is a rechargeable battery containing an active material capable of intercalation and deintercalation of lithium ions. The lithium ion battery provides high energy density, but there is a problem with dendrite occurring during use. Excessively grown dendrite may penetrate a separator of a battery cell, causing an internal short circuit in the battery cell, and may also cause the battery cell to ignite.

The above-described information disclosed in the technology behind this invention is only intended to improve understanding of the background of the present disclosure, and may therefore include information that does not constitute conventional art.

### SUMMARY OF THE INVENTION

The present disclosure is intended to provide a cell balancing method that can suppress dendrite growth, and a cell balancing device and battery pack that perform the method.

However, the technical object that the present disclosure seeks to solve is not limited to the above-mentioned problems, and other problems not mentioned can be clearly understood by a person of an ordinary skill in the art from the description of the invention described below.

One aspect of the present disclosure to solve the technical object relates to a cell balancing device. The cell balancing device may include: a storage device that stores a balancing profile for cell balancing; a balancing device configured to perform a discharge function for cell balancing of a plurality of battery cells; and a first controller configured to control the balancing device to perform pulse discharge for a balancing target battery cell selected from among the plurality of battery cells referring to the balancing profile if the cell balancing is required. The balancing profile may include a pulse period and a duty cycle set based on a natural frequency of a dendrite. The balancing device may be further configured to perform the pulse discharge according to a pulse signal that satisfies the pulse period and the duty cycle.

The balancing device may include a balancing resistor and a balancing switch for each of the plurality of battery cells. The balancing switch corresponding to the balancing target battery cell may repeat switching according to the pulse signal during the pulse discharge.

The balancing profile may further include a continuous discharge time for cell balancing. The first controller may be further configured to control the balancing device to perform continuous discharge during the continuous discharge time before performing the pulse discharge for the balancing target battery cell.

The balancing switch corresponding to the balancing target battery cell may maintain in an on state during the continuous discharge time during the continuous discharge.

The balancing profile may further include a pulse discharge time. The first controller may be further configured to control the balancing device to resume the continuous discharge for the balancing target battery cell if the pulse discharge is carried out during the pulse discharge time before cell balancing of the balancing target battery cell is completed.

If a temperature of the balancing target battery cell rises above a temperature threshold value while the pulse discharge is performed, the first controller may be further configured to control the balancing device to terminate the pulse discharge for the balancing target battery cell and resume the continuous discharge.

If a temperature of the balancing target battery cell rises above a temperature threshold value while the continuous discharge is being performed, the first controller may be further configured to terminate discharge for the balancing target battery cell.

If a temperature of the balancing target battery cell rises above a temperature threshold value while discharge for cell balancing is being performed for the balancing target battery cell, the first controller may be further configured to terminate discharge for the balancing target battery cell.

The cell balancing device may further include: a measuring device configured to measure a voltage of each of the plurality of battery cells; and a second controller configured to determine a start time and a completion time of cell balancing according to the voltage of the plurality of battery cells. If a balancing start signal for the balancing target battery cell is received from the second controller, the first controller may be further configured to control the balancing device to start discharge for the balancing target battery cell. If a balancing completion signal for the balancing target battery cell is received from the second controller, the first controller may be further configured to control the balancing device to terminate discharge for the balancing target battery cell.

Another aspect of the present disclosure relates to a battery pack. A battery pack may include a battery module comprising a plurality of battery cells and the cell balancing device including at least one of the above-described features.

Another aspect of the present disclosure relates to a cell balancing method of a battery pack including a plurality of battery cells. The cell balancing method may include: selecting a balancing target battery cell from among the plurality of battery cells if cell balancing is required; and discharging the balancing target battery cell based on a balancing profile until the cell balancing is completed. The balancing profile may include a pulse period and a duty cycle set based on a natural frequency of a dendrite. The discharging may include: generating a pulse signal to satisfy the pulse period and the duty cycle: and pulse discharging the balancing target battery cell based on the pulse signal.

The pulse discharging may include controlling a balancing switch corresponding to the balancing target battery cell to repeat switching based on the pulse signal.

The balancing profile may further include a continuous discharge time for cell balancing. The discharging may further include continuous discharging the balancing target battery cell during the continuous discharge time before the pulse discharging.

The continuous discharging may include controlling the balancing switch to be maintained in an on state during the continuous discharge time.

The balancing profile may further include a pulse discharge. The cell balancing method may further include resuming continuous discharge for the balancing target battery cell if the pulse discharging is performed during the pulse discharge time before cell balancing of the balancing target battery cell is completed.

The cell balancing method may include: monitoring a temperature of the balancing target battery cell; terminating the pulse discharge for the balancing target battery cell if the temperature rises above a temperature threshold value while the pulse discharging is being performed; and resuming continuous discharge for the balancing target battery cell.

The cell balancing method may include: monitoring a temperature of the balancing target battery cell; and terminating discharge for the balancing target battery cell if the temperature rises above a temperature threshold value while the continuous discharging is being performed.

The cell balancing method may further include: monitoring a temperature of the balancing target battery cell; and terminating discharge for the balancing target battery cell if the temperature rises above a temperature threshold value while discharge for cell balancing for the balancing target battery cell is being performed.

According to the present disclosure, dendrite growth of a battery cell can be suppressed through cell balancing.

However, the effects that can be obtained through the present disclosure are not limited to the above-mentioned effects, and other technical effects not mentioned can be clearly understood by a person of an ordinary skill in the art from the description of the invention described below.

## BRIEF DESCRIPTION OF THE DRAWINGS

The following drawings attached to this specification illustrate a preferred embodiment of the present disclosure, and together with the detailed description of the invention described later, serve to further understand the technical idea of the present disclosure, and therefore that the present disclosure should not be interpreted as limited to the matters stated in the drawings.

FIG. 1 schematically illustrates a battery pack according to an embodiment.
FIG. 2 illustrates an example of the balancing circuit used in the cell balancing device according to an embodiment.
FIG. 3 schematically illustrates a battery pack according to another embodiment.
FIG. 4 schematically illustrates a cell balancing method of a battery pack according to an embodiment.
FIG. 5 schematically illustrates a cell balancing method of a battery pack according to another embodiment.

## DETAILED DESCRIPTION OF THE EMBODIMENTS

Hereinafter, preferred embodiments of the present disclosure are described in detail below with reference to the attached drawings. Prior to the detailed description of the present invention, the terms or words used in this specification and claims range described below should not be construed as being limited to conventional or dictionary meanings, and the inventor should be interpreted as meaning and concept consistent with the technical idea of the present invention based on the principle that it can be appropriately defined as a concept of a term to describe his/her own invention in the best way. Therefore, embodiments described in the present specification and the configurations shown in the drawings are only the most preferred embodiments of the present invention, and do not represent all the technical spirit of the present invention, and therefore, it should be understood that various equivalents and modifications may be substituted for them at the time of filing the present application. It should also be understood that the term "comprise/include" and/or "comprising/including" used herein shows the presence of the specified features, integers, steps, operations, elements and/or components, but it the presence or addition of one or more other features, integers, steps, operations, components, and/or groups thereof is not excluded. In addition, when describing embodiments of the present disclosure, "~may" and "~may be" may include "one or more embodiments of the present disclosure."

In addition, for ease understanding of the present disclosure, the accompanying drawings are not drawn to real scale, but the dimensions of some components may be exaggerated. In addition, the same reference number may be assigned to the same component in another embodiment.

The statement that two objects of comparison are "the same" means "substantially the same". Therefore, substantial identity may include a deviation that is considered low in the industry, for example, a deviation of less than 5 %. In addition, uniformity of a parameter in a given region may mean uniformity from an average perspective.

Although first, second, and the like are used to describe various configurations elements, these components are of course not limited by these terms. These terms are only used to distinguish one component from another component, and unless specifically stated to the contrary, the first component may also be the second component.

Throughout the specification, unless otherwise stated, each component may be singular or plural.

The placement of any component on the "upper portion (or lower portion)" of a component or the "top (or bottom)" of a component means that any component is placed in contact with the top surface (or bottom surface) of the component and may also mean that other configurations may be interposed between and any configuration placed on (or under) the component.

In addition, when a component is described as being "connected," "coupled," or "linked" to another component, the components may be directly connected or linked to each other, but it should be understood that other components may be "interposed" between each component or each component may be "connected," "combined," or "linked" through other components. In addition, when a part is described to be electrically connected (electrically coupled) to another part, this includes not only the case where it is directly connected, but also the case where it is connected with another element in between.

When "A and/or B" is used throughout the specification, it means A, B or A and B, unless specifically stated to the contrary. In other words, "and/or" includes all or any combination of the listed plurality of items. When "C to D" is used, it means C or higher and D or lower, unless specifically stated to the contrary.

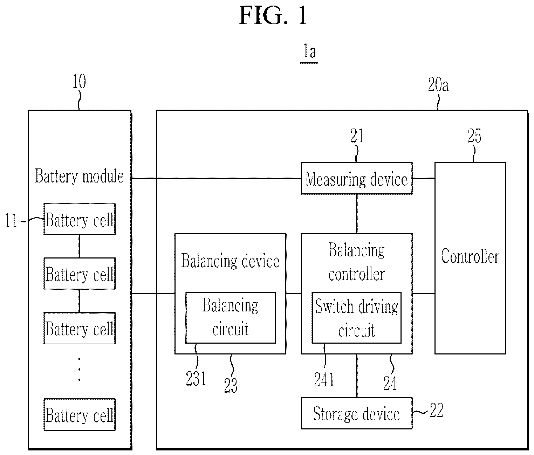

FIG. 1 schematically illustrates a battery pack according to an embodiment.

Referring to FIG. 1, a battery pack 1a may include a battery module 10 and a cell balancing device 20a for cell-balancing the battery module 10.

The battery module 10 may include a plurality of battery cells 11 that are electrically connected to each other in series and/or in parallel.

The cell balancing device 20a may perform cell balancing of the plurality of battery cells 11 that form the battery module 10. The cell balancing device 20a may include a measuring device 21, a storage device 22, a balancing device 23, a balancing controller 24, and a controller 25.

The measuring device 21 may include at least one measuring circuit and/or sensor to measure the state value of the battery module 10. The measuring device 21 may include a voltage measurement circuit for measuring a cell voltage value of each battery cell 11 constituting the battery module 10. The measuring device 21 may include a current measurement circuit for measuring charge and discharge current values of the battery module 10. The measuring device 21 may include a temperature sensor for measuring a temperature value of the battery module 10 or each battery cell 11 constituting the battery module 10.

The storage device 22 may store various data, information, and the like processed by the cell balancing device 20a.

The storage device 22 may store a balancing profile for cell balancing. The balancing profile is data that defines a discharge pattern for cell balancing of the battery cells 11. The balancing profile may include information about continuous discharge and pulse discharge. In this document, continuous discharge may mean an operation in which the battery cell 11 is continuously discharged without on/off switching of the discharge operation. In addition, pulse discharge may refer to a discharge operation in which the discharge of the battery cell 11 is periodically switched on/off.

Continuous discharge information may include continuous discharge time, that is, the duration of the continuous discharge operation. The continuous discharge operation is an operation to activate the lithium ion in the battery cell 11. The continuous discharge time mat be set based on the time from the start of discharge of the battery cell 11 for balancing until the lithium ion permeability (LIP) reaches its maximum. In other words, the continuous discharge time may correspond to the time it takes from the start of discharge until the LIP reaches its maximum. LIP may represent the ratio and speed of lithium ions passing through a separator inside the battery cell 11. Therefore, maximizing LIP may mean that the ratio and speed of lithium ions passing through the separator are maximized. The time it takes for LIP to reach maximum may vary depending on the temperature of the battery cell 11. Therefore, continuous discharge information may include information about the continuous discharge time corresponding to each temperature section.

Pulse discharge information may include characteristic values (pulse period and duty cycle) of a pulse signal for generating pulse discharge. The characteristic value of the pulse signal may be determined to suppress dendrite growth through pulse discharge. For example, a pulse period of a pulse signal may be determined based on the natural frequency (or natural resonance frequency) of the dendrite.

The pulse discharge information may further include pulse discharge time, that is, the duration of the pulse discharge operation.

When resonance is caused by applying a vibration signal to dendrite, the formation of dendrite may be suppressed and decomposition of already formed dendrite may be promoted. Therefore, the pulse signal in the pulse discharge section may be set to generate resonance of the dendrite. The natural frequency of the dendrite may be measured using a spectrum analyzer during the development or manufacturing process of the battery cell 11. The natural frequency of the dendrite may be determined through modeling of the battery cell 11 during the development or manufacturing process of the battery cell 11.

Equation 1 below represents a method for calculating the natural frequency of dendrite.

[Equation 1]

$$f = \frac{1}{2\pi}\sqrt{\frac{k}{\rho\left(\frac{4}{3}\pi r^3\right)}}$$

In Equation 1, k denotes an elasticity coefficient of lithium ion. The elasticity coefficient of lithium ion is approximately 11 GPa. $\rho$ represents the density of lithium ion. The density of lithium ion may be measured during the development or manufacturing process of the battery cell 11, or determined through modeling. For example, the density of lithium ion may be approximately 534 kg/m3. r represents the radius of the dendrite crystal. The radius of dendrite crystals may be measured during the development or manufacturing process of the battery cell 11, or determined through modeling.

After the natural frequency f of the dendrite is determined, a characteristic value of the pulse signal for pulse discharge may be determined based on the determined natural frequency. For example, the pulse period (i.e., switching cycle) of the pulse signal may be determined as the reciprocal (1/f) of the natural frequency of the dendrite. In addition, the duty cycle of the pulse signal may be determined based on a target current value during the pulse discharge section. That is, the duty cycle of the pulse signal may be determined based on the maximum value of discharge current during the pulse discharge section (discharge current value in the on-duty section) and an average current value of a target pulse discharge section. For example, when the maximum value of discharge current is 2.5 A and the average current value in the target pulse discharge section is 2 A, the duty cycle of the pulse signal may be determined as 2.5 A/2 A=0.8 (or 80 %).

The balancing profile is determined in advance during the development or manufacturing process of the battery cell 11 and may be stored in advance in the storage device 22 during the manufacturing process of the battery pack 1a.

The balancing device 23 may perform the function of discharging battery cell 11, which is selected as a balancing target (i.e., selected as a discharge target) among the battery cells 11 for cell balancing. The balancing device 23 may include the balancing circuit 231, which is a discharge circuit for the discharging battery cells 11.

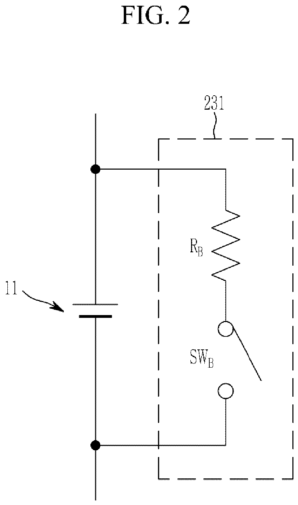

FIG. 2 illustrates an example of the balancing circuit used in the cell balancing device according to an embodiment.

Referring to FIG. 2, the balancing circuit 231 may include a balancing resistor $R_B$ and a balancing switch $SW_B$ that are connected in series between opposite ends of each battery cell 11. When the balancing switch $SW_B$ is turned on balancing circuit 231, the balancing circuit 231 may discharge the battery cell 11 through the balancing resistor $R_B$.

Referring back to FIG. 1, the balancing controller 24 may control the balancing device 23 to turn on/off (or activate/deactivate) the discharge of each battery cell 11. The balancing controller 24 may include a switch driving circuit 241 to turn on/off the balancing switch (see reference numeral $SW_B$ in FIG. 2) corresponding to each battery cell 11.

The balancing controller 24 may receive a balancing start signal and information about the battery cell to be balanced from the controller 25. When the balancing start signal is received, the balancing controller 24 may control the corresponding balancing switch $SW_B$ through the switch driving circuit 241 such that discharge of the battery cell 11 selected as the balancing target begins.

The balancing controller 24 may control the discharge of the battery cell to be balanced based on the balancing profile stored in the storage device 22. In other words, the balancing controller 24 may control the balancing device 23 such that continuous discharge and pulse discharge are performed sequentially for the battery cell to be balanced based on the balancing profile.

When the discharge of the balancing target battery cell starts, the balancing controller 24 may first control the balancing device 23 to discharge the balancing target battery cell during the continuous discharge time defined in the balancing profile. In other words, the balancing controller 24 may control the balancing switch $SW_B$ of the battery cell to be balanced to remain on during the continuous discharge time defined in the balancing profile.

The balancing controller 24 switches the balancing switch $SW_B$ of the balancing target battery cell such that the balancing target battery cell pulse discharges when continuous discharge of the balancing target battery cell is completed (i.e., when continuous discharge of the balancing target battery cell is performed for a predetermined continuous discharge time)

The balancing controller 24 may generate a pulse signal for pulse discharge based on pulse discharge information included in the balancing profile. That is, the balancing controller 24 may generate a pulse signal to satisfy the pulse period and duty cycle defined in pulse discharge information. When the pulse signal is generated, the balancing controller 24 iteratively switches the balancing switch SW$_B$ of the balancing target battery cell using the pulse signal, thereby causing pulse discharge of the balancing target battery cell.

The balancing controller 24 may control the balancing device 23 such that continuous discharge and pulse discharge are repeated while cell balancing is performed. After the pulse discharge is performed during the pulse discharge time defined in the balancing profile, the balancing controller 24 may control the balancing device 23 to end the pulse discharge and resume continuous discharge. Then, when continuous discharge progresses during the continuous discharge time defined in the balancing profile, the balancing controller 24 may control the balancing device 23 to end the continuous discharge and restart pulse discharge. Until a balancing completion signal for the balancing target battery cell is received from the controller 25, the balancing controller 24 may control the balancing device 23 to repeat the continuous discharge and the pulse discharge for the balancing target battery cell in this manner. The number of repetitions of continuous discharge and pulse discharge may vary depending on the balancing amount of the battery cell 11 to be discharged.

The balancing profile may further include a temperature threshold value. The balancing controller 24 may continuously detect the temperature of the balancing target battery cell through the measuring device 21. The balancing controller 24 may compare the detected temperature with a temperature threshold value included in the balancing profile. The balancing controller 24 may control the discharge of the balancing target battery cell according to the comparison result between the detected temperature and the temperature threshold value.

When the temperature of the balancing target battery cell that is currently discharging for cell balancing is above the temperature threshold value, the balancing controller 24 may prohibit pulse discharge for the battery cell. For example, when the temperature of the balancing target battery cell undergoing the pulse discharge becomes higher than the temperature threshold value, the balancing controller 24 may control the balancing device 23 to stop pulse discharge for the battery cell and perform continuous discharge.

In this case, the balancing controller 24 may permit pulse discharge for the battery cell when the temperature of the battery cell falls below the threshold value. In other words, the balancing controller 24 may resume discharge control based on the balancing profile for the balancing target battery cell of which the temperature has fallen below the threshold value. To ensure safety, the balancing controller 24 may continue to prohibit the pulse discharge of the corresponding battery cell even if the temperature of the balancing target battery cell falls below the threshold value. In this case, the balancing controller 24 may control the balancing device 23 such that only continuous discharge occurs for the corresponding battery cell until balancing of the corresponding battery cell is completed.

When the temperature of the balancing target battery cell that is currently discharging for cell balancing rises above the temperature threshold value, the balancing controller 24 may control the balancing device 23 to temporarily suspend the discharge of the relevant battery cell. In this case, when the temperature of the battery cell decreases below the threshold value later, the balancing controller 24 may control the balancing device 23 to resume discharge for the battery cell. In other words, the balancing controller 240 may resume discharge control based on the balancing profile for the balancing target battery cell of which the temperature has fallen below the threshold value.

The ensure safety, the balancing controller 24 may control the balancing device 23 to end the cell balancing of the corresponding battery cell when the temperature of the balancing target battery cell undergoing discharge for current cell balancing rises above the temperature threshold value. In this case, the balancing controller 24 may transmit a balancing completion signal to the controller 25, indicating that cell balancing has ended due to safety issues.

The balancing controller 24 may receive the balancing completion signal from the controller 25. When receiving the balancing completion signal from the controller 25, the balancing controller 24 may control the balancing device 23 to end the discharge of the battery cells 11.

When the balancing controller 24 receives the balancing completion signal from the controller 25, it may also receive information about the battery cell 11, which is the target of balancing completion. In this case, the balancing controller 24 may control the balancing device 23 to terminate discharge only for battery cell 11, which is the target of balancing completion, among the battery cells in discharge.

The controller 25 may continuously detect the status (voltage, current, temperature, and the like) of the battery cells 11 included in the battery module 10 through the measuring device 21. The controller 25 may manage the overall operation of the battery pack 1a, including charge and discharge, cell balancing, and protection functions, based on the detected status of the battery cells 11.

The controller 25 may control the cell balancing of the battery module 10 based on the voltage value of the battery cells 11. The controller 25 may determine a balancing target battery cell among the battery cells 11 based on a voltage value of each battery cell 11. The controller 25 may determine a balancing start time and a balancing completion time of a target battery cell based on the voltage value of each battery cell 11. When it is determined that balancing of a specific battery cell 11 is necessary, the controller 25 may transmit identification information of the battery cell 11 selected as a balancing target and a balancing start signal to the balancing controller 24. When it is determined that balancing of the balancing target battery cell is complete, the controller 25 may transmit identification information of the battery cell 11 for which balancing has been completed and a balancing completion signal to the balancing controller 24.

In the aforementioned cell balancing device 20a, at least one of the measuring device 21, the balancing device 23, and the balancing controller 24 may be integrated as a part of an analog front end (AFE) integrated chip (IC) of the battery pack 1a. In addition, the controller 25 may be integrated to a part of the battery management system (BMS) of the battery pack 1a.

Meanwhile, in the above-described embodiment, it is exemplarily described that the controller 25 only performs a trigger role (notification of start or completion) of the cell balancing operation, and functions to control continuous discharge and pulse discharge of the balancing target battery cell based on the balancing profile and the temperature of each battery cell 11 are performed by the balancing controller 24.

However, in another embodiment, some of the functions of the balancing controller 24 described above, that is, the function of controlling continuous discharge and pulse discharge of the balancing target battery cell based on the balancing profile and the temperature of each battery cell 11, may be performed by the controller 25.

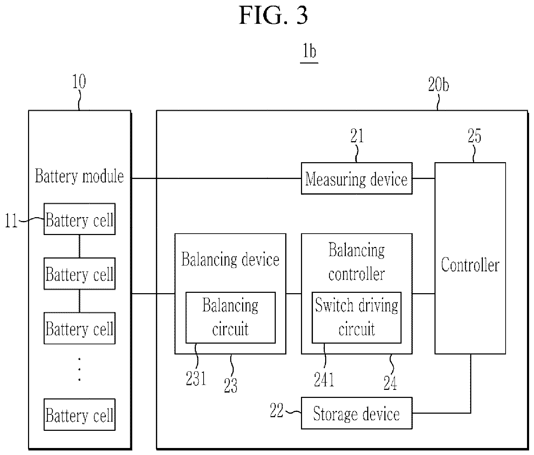

FIG. 3 schematically illustrates a battery pack according to another embodiment.

Referring to FIG. 3, a battery pack 1b may include a battery module 10 and a cell balancing device 20b for cell balancing of the battery module 10. In addition, the cell balancing device 20b may include a measuring device 21, a storage device 22, a balancing device 23, a balancing controller 24, and a controller 25.

Hereinafter, to avoid redundant explanation, among the components of the battery pack 1b, detailed descriptions of components that have the same composition and function as the battery pack 1a of FIG. 1 will be omitted.

The balancing controller 24 of the battery pack 1b may turn-on/off (or activates/deactivates) discharge of each battery cell 11 by controlling the balancing device 23. The balancing controller 24 may turn on/off the discharge of each battery cell 11 by turning on/off a balancing switch (refer to reference numeral $SW_B$ in FIG. 2) corresponding to each battery cell 11 through a switch driving circuit 241.

The balancing controller 24 may receive information about a balancing start signal and a balancing target battery cell from the controller 25. The balancing controller 24 may receive a control signal from the controller 25 to select a discharge mode (continuous discharge mode or pulse discharge mode) of the balancing target battery cell. The balancing controller 24 may receive a balancing completion signal from the controller 25 and information about the battery cell for which balancing is to be completed.

When the balancing start signal is received, the balancing controller 24 may control a corresponding balancing switch $SW_B$ through a switch driving circuit 241 such that discharge of a battery cell 11 selected as a balancing target can be started.

When the discharge of the balancing target battery cell starts, the balancing controller 24 may control the corresponding balancing switch $SW_B$ for continuous discharge or pulse discharge of the balancing target battery cell according to a control signal received from the controller 25. When the control signal indicates a continuous discharge mode, the balancing controller 24 may control the balancing switch $SW_B$ of the balancing target battery cell to remain on through the switch driving circuit 241. When the control signal indicates a pulse discharge mode, the balancing controller 24 output a pulse signal generated by the switch driving circuit 241 to the corresponding balancing switch $SW_B$ such that the balancing switch $SW_B$ of the balancing target battery cell is turned on/turned off with a predetermined cycle. In this case, the frequency of the pulse signal generated by the switch driving circuit 241 may correspond to the natural frequency of the dendrite.

When the balancing completion signal is received, the balancing controller 24 may control the corresponding balancing switch $SW_B$ through the switch driving circuit 241 to thereby end the discharge of the battery cell 11 selected as a balancing termination target.

The controller 25 may continuously detect the status (voltage, current, temperature, and the like) of the battery cells 11 included in the battery module 10 through the measuring device 21. The controller 25 may manage the overall operation of a battery pack 1a, including charge and discharge, cell balancing, and protection functions, based on the detected status of the battery cells 11.

The controller 25 may determine the balancing target battery cell among the battery cells 11 based on a voltage value of each battery cell 11 detected through the measuring device 21.

The controller 25 may determine a starting point of balancing and a completion point of balancing of the balancing target battery cell based on the voltage value of each battery cell 11. When it is determined that balancing of a specific battery cell 11 is necessary, the controller 25 may transmit identification information of the battery cell 11 selected as a balancing target and a balancing start signal to the balancing controller 24. When it is determined that balancing of the balancing target battery cell is complete, the controller 25 may transmit identification information of the battery cell 11 for which balancing has been completed and a balancing completion signal to the balancing controller 24.

The controller 25 may control the cell balancing discharge mode of the balancing target battery cell based on the balancing profile stored in the storage device 22. That is, the controller 25 can control balancing device 23 through balancing controller 24 so that continuous discharge and pulse discharge are performed sequentially for the balancing target battery cell based on the balancing profile.

When the discharge of the balancing target battery cell begins, the controller 25 may first control the balancing controller 24 such that continuous discharge of the balancing target battery cell proceeds during the continuous discharge time defined in the balancing profile. For example, the controller 25 transmits a control signal indicating continuous discharge along with the balancing start signal of the balancing target battery cell to the balancing controller 24, thereby controlling the balancing controller 24 to start cell balancing of the balancing target battery cell and simultaneously start continuous discharge.

After that, when the continuous discharge time defined in the balancing profile has elapsed, the controller 25 may transmit a control signal instructing to change the discharge mode to a pulse discharge mode to the balancing controller 24. When the controller 25 instructs to change the discharge mode to the pulse discharge mode, it may also transmit a control signal to control the pulse signal. That is, the controller 25 may transmit a control signal to the balancing controller 24 to control the pulse signal output from the balancing controller 24 to satisfy the pulse period and the duty cycle defined in the balancing profile.

The controller 25 may control the balancing controller 24 to iteratively perform the continuous discharge and the pulse discharge while cell balancing is performed. When balancing of the balancing target battery cell is not completed even after the pulse discharge is performed during the pulse discharge time defined in the balancing profile, the controller 25 may control the balancing controller 24 to re-perform the continuous discharge and the pulse discharge for the corresponding battery cell. Until balancing of the balancing target battery cell is completed, the controller 25 may control the balancing controller 24 based on the balancing profile such that the continuous discharge and the pulse discharge for the corresponding battery cell are repeated. The number of repetitions of continuous discharge and pulse discharge may vary depending on the balancing amount of the balancing target battery cell 11.

The controller 25 continuously detects the temperature of the balancing target battery cell through the measuring device 21 and compares the detected temperature with the temperature threshold value included in the balancing profile. The controller 25 may control the discharge of the balancing target battery cell according to the comparison result between the detected temperature and the temperature threshold value.

The controller 25 may prohibit pulse discharge for the battery cell when the temperature of the balancing target battery cell currently discharging for cell balancing exceeds the temperature threshold value. For example, when a temperature of a balancing target battery cell undergoing pulse discharge rises above the temperature threshold value, the controller 25 may control the balancing controller 24 to stop the pulse discharge for the battery cell and perform continuous discharge.

In this case, the controller 25 may later permit pulse discharge for the battery cell when the temperature of the battery cell falls below the threshold value. In other words, the controller 25 may resume discharge control based on the balancing profile for the balancing target battery cell of which the temperature has fallen below the threshold value. To ensure safety, the controller 25 may continuously prohibit the pulse discharge of the corresponding battery cell even if the temperature of the balancing target battery cell falls below the threshold value. In this case, the controller 25 may control the balancing controller 24 such that only continuous discharge progresses for the corresponding battery cell until balancing of the corresponding battery cell is completed.

The controller 25 may control the balancing controller 24 to temporarily stop discharge of the battery cell when the temperature of the balancing target battery cell that is currently discharging for cell balancing rises above the temperature threshold value. In this case, the controller 25 may control the balancing controller 24 to resume discharge for the battery cell when the temperature of the battery cell falls below the threshold value. In other words, the controller 25 may resume discharge control based on the balancing profile for the balancing target battery cell of which temperature has fallen below the threshold value.

To ensure safety, the controller 25 may control the balancing controller 24 to terminate cell balancing of the corresponding battery cell when the temperature of the balancing target battery cell that is currently discharging for cell balancing rises above the temperature threshold value.

In the aforementioned cell balancing device 20b, at least one of the balancing device 23 and the balancing controller 24 may be integrated as a part of the AFE IC of the battery pack 1b. In addition, the controller 25 may be integrated as a part of the BMS of the battery pack 1b.

Meanwhile, in the above-described embodiment, it is described that the controller 25 only performs the trigger role (notification of start or completion) of the cell balancing operation, and functions of controls continuous discharge and pulse discharge of the balancing target battery cell based on the balancing profile and the temperature of each battery cell 11 are performed by the balancing controller 24 as an example.

However, in another embodiment, some of the functions of the balancing controller 24 described above, that is, the function of controlling continuous discharge and pulse discharge of the balancing target battery cell based on the balancing profile and the temperature of each battery cell 11, may be performed by the controller 25. In this case, the controller 25 may determine the start/termination point of each discharge section (continuous discharge section or pulse discharge section) based on the balancing profile and the temperature of each battery cell 11, and may transmit a control signal that instructs the start/termination point of each discharge section according to the determined start/finishing point to the balancing controller 24. In addition, the balancing controller 24 may control the balancing device 23 to start/terminate continuous/pulse discharge of the balancing target battery cell according to the control signal received from the controller 25.

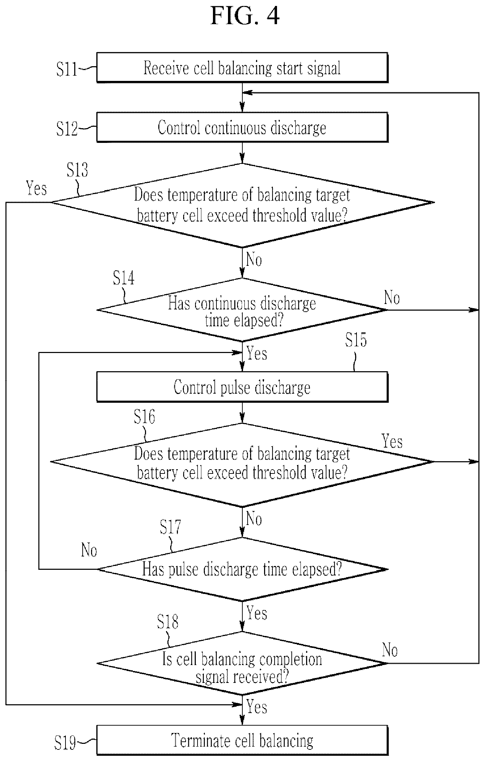

FIG. 4 schematically illustrates a cell balancing method of a battery pack according to an embodiment. A method shown in FIG. 4 may be carried out by the balancing controller 24 of the cell balancing device 20a described with reference to FIG. 1. In the following description, for better understanding and ease of description, the case where the cell balancing is performed for one battery cell will be described as an example.

Referring to FIG. 4, the balancing controller 24 may receive a cell balancing start signal from the controller 25 (S11). The controller 25 may determine whether cell balancing of the battery module 10 is necessary based on a voltage value measured for each battery cell 11 through the measuring device 21. When the controller 25 determines that cell balancing is necessary, the controller 25 may transmit the cell balancing start signal to the balancing controller 24 along with identification information about the balancing target battery cell.

As the cell balancing start signal is received, the balancing controller 24 may control the balancing device 23 to start continuous discharge of the balancing target battery cell based on the predetermined balancing profile (S12).

The balancing controller 24 may continuously monitor a temperature of the corresponding battery cell while continuous discharge is in progress for the balancing target battery cell and check whether the temperature of the corresponding battery cell exceeds a predetermined threshold value (S13). When the balancing controller 24 determines that the temperature of the balancing target battery cell that is continuously discharging exceeds the threshold value, the balancing controller 24 may control the balancing device 23 to terminate cell balancing for the corresponding battery cell (S19). That is, the balancing controller 24 may control the balancing device 23 to terminate discharge for the corresponding battery cell.

When the temperature of the balancing target battery cell in continuous discharge remains below the threshold value, the balancing controller 24 may control the balancing device 23 to maintain continuous discharge of the balancing target battery cell until a predetermined continuous discharge time has elapsed.

When the predetermined continuous discharge time has elapsed from the time the continuous discharge of the balancing target battery cell starts (S14), the balancing controller 24 may control the balancing device 23 to start the pulse discharge of the balancing target battery cell (S15). In S15, the balancing controller 24 may generate a pulse signal based on the balancing profile. In addition, the balancing controller 24 may use the generated pulse signal to control the balancing device 23 such that the balancing switch of the balancing target battery cell is iteratively turned on/off.

The balancing controller 24 continuously monitors the temperature of the relevant battery cell while pulse discharge is in progress for the balancing target battery cell, and may check whether the temperature of the relevant battery cell exceeds a predetermined threshold value (S16). When the temperature of the balancing target battery cell undergoing pulse discharge is determined to be above the threshold value, the balancing controller 24 may control the balancing device 23 to terminate the pulse discharge for the corresponding battery cell and resume continuous discharge.

When the temperature of the balancing target battery cell in pulse discharge remains below the threshold value, the balancing controller 24 may control the balancing device 23 to maintain pulse discharge of the balancing target battery cell until the predetermined pulse discharge time has elapsed.

The balancing controller 24 may control the balancing device 23 to terminate pulse discharge for the corresponding battery cell when a predetermined pulse discharge time has elapsed from the time the pulse discharge of the balancing target battery cell is started (S17).

In addition, when it is confirmed that the cell balancing completion signal for the corresponding battery cell has not been received from the controller 25 (S18), the balancing controller 24 may return to step S12 and control the balancing device 23 to resume continuous discharge for the corresponding battery cell. On the other hand, when the balancing controller 24 confirms that the cell balancing completion signal for the balancing target battery cell has been received from the controller 25, the balancing controller 24 may control the balancing device 23 to terminate cell balancing for the corresponding battery cell (S19).

Meanwhile, although it is not shown in FIG. 4, When discharge for the cell balancing for the balancing target battery cell is in progress and a cell balancing completion signal for the corresponding battery cell is received from the controller 25, the balancing controller 24 may control the balancing device 23 to immediately terminate the cell balancing for the corresponding battery cell.

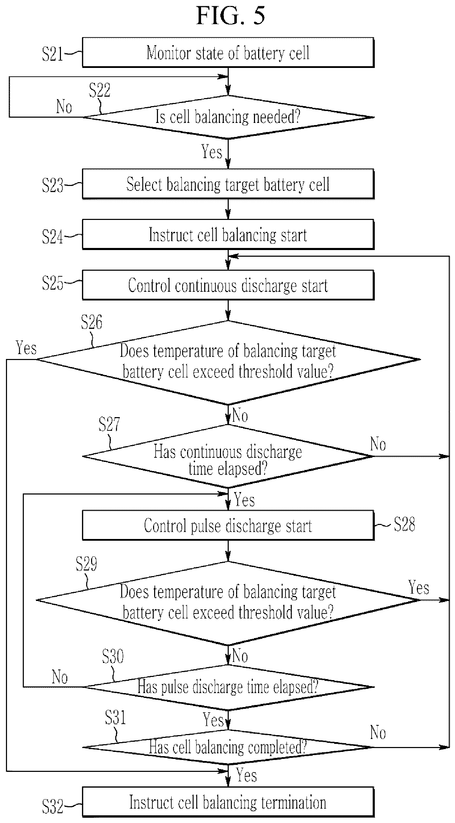

FIG. 5 schematically illustrates a cell balancing method of a battery pack according to another embodiment. A method shown in FIG. 5 may be carried out by the balancing controller 25 of the cell balancing device 20b described with reference to FIG. 3. In the following description, for better understanding and ease of description, the case where the cell balancing is performed for one battery cell will be described as an example.

Referring to FIG. 5, the controller 25 may monitor the status of the battery cells 11 through the measuring device 21 (S21) to determine whether cell balancing is necessary. When it is determined that cell balancing is necessary (S22), the controller 25 may select a balancing target battery cell based on the voltage value of each battery cell 11 (S23).

When a balancing target battery cell is selected, the controller 25 may instruct the balancing controller 24 to start cell balancing by transmitting identification information of the selected battery cell along with a cell balancing start signal to the balancing controller 24 (S24). In addition, the controller 25 may control the balancing controller 24 such that continuous discharge for the balancing target battery cell is started first, based on a predetermined balancing profile (S25). In other words, the controller 25 may transmit a control signal instructing operation in continuous discharge mode to the balancing controller 24.

While the continuous discharge is in progress for the balancing target battery cell, the controller 25 may continuously monitor a temperature of the corresponding battery cell and check whether the temperature of the corresponding battery cell exceeds a predetermined threshold value (S26). When the temperature of the balancing target battery cell in continuous discharge is determined to be above the threshold value, the controller 25 may control the balancing controller 24 to terminate cell balancing for the corresponding battery cell (S32). Accordingly, the balancing controller 24 may control the balancing device 23 to terminate discharge for the corresponding battery cell.

When the temperature of the balancing target battery cell during continuous discharge remains below the threshold value, the controller 25 may control the balancing controller 24 to maintain continuous discharge of the balancing target battery cell until a predetermined continuous discharge time elapses.

When the predetermined continuous discharge time elapses from the time the continuous discharge of the balancing target battery cell starts (S27), the controller 25 may control the balancing controller 24 to start the pulse discharge of the balancing target battery cell (S28). That is, the controller 25 may transmit a control signal instructing operation in pulse discharge mode to the balancing controller 24. In S28, the controller 25 may set a pulse period and a duty cycle of the pulse signal based on the pulse period and duty cycle defined in the balancing profile for the balancing controller 24 to control the balancing switch of the balancing target battery cell.

The controller 25 may continuously monitor the temperature of the corresponding battery cell while pulse discharge is in progress for the balancing target battery cell and check whether the temperature of the relevant battery cell is above a predetermined threshold value (S29). When it is determined the temperature of the balancing target battery cell undergoing pulse discharge is determined to be above the threshold value, controller 25 may control the balancing controller 24 to terminate the pulse discharge for the corresponding battery cell and resume continuous discharge.

When the temperature of the balancing target battery cell undergoing pulse discharge remains below the threshold value, the controller 25 may control the balancing controller 24 to maintain pulse discharge of the balancing target battery cell until the predetermined pulse discharge time elapses.

When the predetermined pulse discharge time elapses from the point when pulse discharge of the balancing target battery cell is started (S30), the controller 25 may control the balancing controller 24 to terminate the pulse discharge for the corresponding battery cell.

In addition, the controller 25 determines whether cell balancing of the balancing target battery cell has been completed (S31), and may control the balancing controller 24 to return to step S25 and resumes continuous discharge for the corresponding battery cell when cell balancing of the corresponding battery cell is not completed

On the other hand, when cell balancing is completed for the balancing target battery cell, the controller 25 may control the balancing controller 24 to terminate cell balancing for the corresponding battery cell (S32).

Meanwhile, although it is not shown in FIG. 5, when it is determined that cell balancing of the battery cell is completed while discharge for cell balancing is in progress for the balancing target battery cell, the controller 25 may control the balancing controller 24 to immediately terminate cell balancing for the corresponding battery cell.

According to the above-described embodiments, the cell balancing devices 20a and 20b suppress dendrite growth by generating pulse discharge based on the natural frequency of dendrite during cell balancing, thereby increasing the balancing efficiency of the battery cells 11. In addition, there is no need for a separate component or operation mode for pulse discharge by performing pulse discharge during the cell balancing process.

In the above, although the present disclosure has been described by limited embodiments and drawings, the present disclosure is not limited thereto and various modifications and variations are possible within the equivalent range of the patent claims to be described based on the technical ideas of the present disclosure and the following by a person of an ordinary skill in the technical field to which the present disclosure belongs.

**Claims**

1. A cell balancing device (20a, 20b) comprising;

   a storage device (22) that stores a balancing profile for cell balancing;
   a balancing device (23) configured to perform a discharge function for cell balancing of a plurality of battery cells (11); and
   a first controller (24) configured to control the balancing device (23) to perform pulse discharge for a balancing target battery cell selected from among the plurality of battery cells (11) referring to the balancing profile if the cell balancing is required,
   wherein the balancing profile includes a pulse period and a duty cycle set based on a natural frequency of a dendrite, and
   wherein the balancing device (23) is further configured to perform the pulse discharge according to a pulse signal that satisfies the pulse period and the duty cycle.

2. The cell balancing device as claimed in claim 1, wherein:

   the balancing device (23) includes a balancing resistor ($R_B$) and a balancing switch ($SW_B$) for each of the plurality of battery cells (11), and
   the balancing switch ($SW_B$) corresponding to the balancing target battery cell repeats switching according to the pulse signal during the pulse discharge.

3. The cell balancing device as claimed in claim 2, wherein:

   the balancing profile further includes a continuous discharge time for cell balancing, and
   the first controller (24) is further configured to control the balancing device (23) to perform continuous discharge during the continuous discharge time before performing the pulse discharge for the balancing target battery cell.

4. The cell balancing device as claimed in claim 3, wherein:
   the balancing switch ($SW_B$) corresponding to the balancing target battery cell is maintained in an on state during the continuous discharge time.

5. The cell balancing device as claimed in claim 3 or claim 4, wherein:

   the balancing profile further includes a pulse discharge time, and
   the first controller (24) is further configured to control the balancing device (23) to resume the continuous discharge for the balancing target battery cell if the pulse discharge is carried out during the pulse discharge time before cell balancing of the balancing target battery cell is completed.

6. The cell balancing device as claimed in any one of claim 3 to claim 5, wherein:
   if a temperature of the balancing target battery cell rises above a temperature threshold value while the pulse discharge is performed, the first controller (24) is further configured to control the balancing device (23) to terminate the pulse discharge for the balancing target battery cell and resume the continuous discharge.

7. The cell balancing device as claimed in any one of claim 3 to claim 6, wherein:
   if a temperature of the balancing target battery cell rises above a temperature threshold value while the continuous discharge is being performed, the first controller (24) is further configured to control the balancing device (23) to terminate discharge for the balancing target battery cell.

8. The cell balancing device as claimed in any one of claim 3 to claim 7, wherein:
   if a temperature of the balancing target battery cell rises above a temperature threshold value while discharge for cell balancing is being performed for the balancing target battery cell, the first controller (24) is further configured to control the balancing device (23) to terminate discharge for the balancing target battery cell.

9. The cell balancing device as claimed in any one of claim 1 to claim 8, further comprising:

   a measuring device (21) configured to measure a voltage of each of the plurality of battery cells (11); and
   a second controller (25) configured to determine a start time and a completion time of cell balancing according to the voltage of the plurality of battery cells,
   wherein, if a balancing start signal for the balancing target battery cell is received from the second controller (25), the first controller (24) is configured to control the balancing device (23) to start discharge for the balancing target battery cell, and
   wherein, if a balancing completion signal for the balancing target battery cell is received from the second controller (25), the first controller (24) is further configured to control the balancing device (23) to terminate discharge for the balancing target battery cell.

**10.** A battery pack (1a, 1b) comprising:

a battery module (10) including a plurality of battery cells (11); and
the cell balancing device (20a, 20b) according to any one of claim 1 to claim 9.

**11.** A cell balancing method of a battery pack (1a, 1b) including a plurality of battery cells (11), comprising:

selecting a balancing target battery cell from among the plurality of battery cells (11) if cell balancing is required; and
discharging the balancing target battery cell based on a balancing profile until the cell balancing is completed,
wherein the balancing profile includes a pulse period and a duty cycle set based on a natural frequency of a dendrite, and
wherein the discharging includes:

generating a pulse signal to satisfy the pulse period and the duty cycle; and
pulse discharging the balancing target battery cell based on the pulse signal.

**12.** The cell balancing method as claimed in claim 11, wherein:
the pulse discharging includes controlling a balancing switch ($SW_B$) corresponding to the balancing target battery cell to repeat switching based on the pulse signal.

**13.** The cell balancing method as claimed in claim 12, wherein:

the balancing profile further includes a continuous discharge time for cell balancing, and
the discharging further includes continuous discharging the balancing target battery cell during the continuous discharge time before the pulse discharging.

**14.** The cell balancing method as claimed in claim 13, wherein:
the continuous discharging includes controlling the balancing switch ($SW_B$) to be maintained in an on state during the continuous discharge time.

**15.** The cell balancing method as claimed in claim 13 or claim 14, further comprising:

resuming continuous discharge for the balancing target battery cell if the pulse discharging is performed during a pulse discharge time included in the balancing profile before cell balancing of the balancing target battery cell is completed; and/or

monitoring a temperature of the balancing target battery cell, terminating pulse discharge for the balancing target battery cell if the temperature rises above a temperature threshold value while the pulse discharging is being performed, and resuming continuous discharge for the balancing target battery cell; and/or

monitoring a temperature of the balancing target battery cell, and terminating discharge for the balancing target battery cell if the temperature rises above a temperature threshold value while the continuous discharging is being performed; and/or

monitoring a temperature of the balancing target battery cell, and terminating discharge for the balancing target battery cell if the temperature rises above a temperature threshold value while discharge for cell balancing for the balancing target battery cell is being performed.

# FIG. 1

<u>1a</u>

10

20a

21

25

Battery module

Measuring device

Controller

11 — Battery cell

Battery cell

Balancing device

Balancing controller

Battery cell

Balancing circuit

Switch driving circuit

...

231

23

241

24

Battery cell

Storage device ~ 22

## FIG. 2

FIG. 3

<u>1b</u>

# FIG. 4

S11 — Receive cell balancing start signal

S12 — Control continuous discharge

S13

Yes

Does temperature of balancing target battery cell exceed threshold value?

No

S14

Has continuous discharge time elapsed?

No

Yes

S15

Control pulse discharge

S16

Does temperature of balancing target battery cell exceed threshold value?

Yes

No

S17

No

Has pulse discharge time elapsed?

Yes

S18

Is cell balancing completion signal received?

No

Yes

S19 — Terminate cell balancing

# FIG. 5

S21 — Monitor state of battery cell

S22 — Is cell balancing needed? — No

Yes

S23 — Select balancing target battery cell

S24 — Instruct cell balancing start

S25 — Control continuous discharge start

S26 — Does temperature of balancing target battery cell exceed threshold value? — Yes

No

S27 — Has continuous discharge time elapsed? — No

Yes

S28 — Control pulse discharge start

S29 — Does temperature of balancing target battery cell exceed threshold value? — Yes

No

S30 — Has pulse discharge time elapsed? — No

Yes

S31 — Has cell balancing completed? — No

Yes

S32 — Instruct cell balancing termination

Europäisches
Patentamt

European
Patent Office

Office européen
des brevets

**EUROPEAN SEARCH REPORT**

Application Number

EP 25 16 2492

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/219390 A1 (TKACHENKO OLEKSANDR [CA] ET AL) 2 August 2018 (2018-08-02) | 1,2,9-12 | INV. H02J7/00 |
| A | * abstract; figures * * paragraphs [0035], [0050] - [0126] * ----- | 3-8, 13-15 | |
| A | KR 102 309 014 B1 (DTI KOREA CO LTD [KR]) 7 October 2021 (2021-10-07) * abstract; figures * ----- | 1,11 | |
| A | US 2016/072316 A1 (BARSUKOV YEVGEN PAVLOVICH [US] ET AL) 10 March 2016 (2016-03-10) * abstract; figures * * paragraphs [0021] - [0047] * ----- | 1,11 | |

TECHNICAL FIELDS SEARCHED (IPC)

H02J

The present search report has been drawn up for all claims

| Place of search | Date of completion of the search | Examiner |
|---|---|---|
| Munich | 20 August 2025 | Hartmann, Martin |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 16 2492

This annex lists the patent family members relating to the patent documents cited in the above-mentioned European search report.
The members are as contained in the European Patent Office EDP file on
The European Patent Office is in no way liable for these particulars which are merely given for the purpose of information.

20-08-2025

| Patent document cited in search report | Publication date | Patent family member(s) | Publication date |
|---|---|---|---|
| US 2018219390 A1 | 02-08-2018 | NONE | |
| KR 102309014 B1 | 07-10-2021 | NONE | |
| US 2016072316 A1 | 10-03-2016 | CN 104620467 A | 13-05-2015 |
| | | JP 6251746 B2 | 20-12-2017 |
| | | JP 6546641 B2 | 17-07-2019 |
| | | JP 6916452 B2 | 11-08-2021 |
| | | JP 2015528690 A | 28-09-2015 |
| | | JP 2018050466 A | 29-03-2018 |
| | | JP 2019195265 A | 07-11-2019 |
| | | US 2014077752 A1 | 20-03-2014 |
| | | US 2016072316 A1 | 10-03-2016 |
| | | US 2018226810 A1 | 09-08-2018 |
| | | WO 2014043615 A1 | 20-03-2014 |

EPO FORM P0459

For more details about this annex : see Official Journal of the European Patent Office, No. 12/82